# EUROPEAN PATENT APPLICATION

(11) **EP 3 723 137 A1**
(43) Date of publication of application: **14.10.2020**
(21) Application number: 19170134.1
(22) Date of filing: 18.04.2019
(51) Int. Cl.: H01L 29/861, H01L 29/40, H01L 29/06, H01L 21/329

(54) **DIODE STRUCTURE AND MANUFACTURING METHOD THEREOF**

(30) Priority: 10.04.2019 TW 108112455
(71) Applicant: Mosel Vitelic Inc., Hsinchu, Taiwan, R.O.C. (TW)
(72) Inventor: Weng, Hung-Ta, Hsinchu, Taiwan, R.O.C. (TW); Chiu, Yun-Kuei, Hsinchu, Taiwan, R.O.C. (TW); Chu, Chien-Chung, Hsinchu, Taiwan, R.O.C. (TW)
(74) Representative: Uexküll & Stolberg

(57) **Abstract**

A diode structure (1) and a manufacturing method are disclosed. The diode structure (1) includes a first metallic layer (10), a first-type conductive semiconductor layer (11), a second-type conductive semiconductor layer (12), a trench portion (13), and a second metallic layer (14). The first-type conductive semiconductor layer (11) is formed on the first metallic layer (10). The second-type conductive semiconductor layer (12) is formed on the first-type conductive semiconductor layer (11). The first-type conductive semiconductor layer (11) and the second-type conductive semiconductor layer (12) have opposite conductivity and a PN junction (J) is formed therebetween. The trench portion (13) is formed in the second-type conductive semiconductor layer (12) and the first-type conductive semiconductor layer (11). A first contact surface (M1) is formed between the trench portion (13) and the first-type conductive semiconductor layer (11), and a second contact surface (M2) is formed between the trench portion (13) and the second-type conductive semiconductor layer (12). The second metallic layer (14) is formed on the second-type conductive semiconductor layer (12) and the trench portion (13).

## Description

### FIELD OF THE INVENTION

The present disclosure relates to a diode structure, and more particularly to a trench merged PIN Schottky diode structure and a method thereof.

### BACKGROUND OF THE INVENTION

A diode is one of the common components in a circuit system and is widely used in various types of product equipment. The diode structure can be varied according to the practical requirements. For example, both of a PIN diode and a Schottky diode can be used as a power diode. The PIN diode has a high breakdown voltage and a low reverse current, but the switching speed of the PIN diode is slow. On the other hand, the Schottky diode has a fast switching speed, a low conduction voltage drop and a high forward conduction current, but the Schottky diode has a poor leakage characteristic. Therefore, the PIN diode and the Schottky diode are integrated into a diode structure to form a merged PIN Schottky diode structure to achieve the best switching characteristics. However, the conventional merged PIN Schottky diode structure has the PIN diode and the Schottky diode stacked with each other complicatedly. Consequently, the entire volume of the conventional merged PIN Schottky diode structure is large, which is not conductive to the miniaturization of the structure. Furthermore, the leakage characteristics of the conventional merged PIN Schottky diode structure cannot meet the high-frequency requirement.

Therefore, there is a need of providing a trench merged PIN Schottky diode structure and a method thereof to address the above-mentioned issues in prior arts. At the same time, the entire structure is simplified, the process accuracy is improved, and the purpose of optimizing the characteristics of the diode structure is achieved.

### SUMMARY OF THE INVENTION

An object of the present disclosure is to provide a diode structure and a manufacturing method thereof. A trench portion is constructed into the diode structure to form a trench merged PIN Schottky diode structure. It benefits to minimize the size of entire structure and optimize the characteristics of the diode structure at the same time. Consequently, the unit density of the diode structure is increased, the snapback issue is eliminated and the high-frequency requirements are met. It benefits to achieve the purposes of optimizing the characteristics of fast recovery time (low switching loss) and soft recovery (low peak voltage, low EMI and high system efficiency).

Another object of the present disclosure is to provide a diode structure and a manufacturing method thereof. By introducing a trench portion into the diode structure, it benefits to control the doping of the conductive semiconductor material in the manufacturing process, so as to improve the accuracy of the interface between the different conductive semiconductor layers and optimize the performance of the diode structure. On the other hand, the design of the trench portion can be varied according to the practical requirements to enclose a region as a semiconductor unit, so that the unit density of the diode structure is increased, the snapback issue is eliminated, and the high-frequency requirements are met. It benefits to achieve the purposes of optimizing the characteristics of fast recovery time (low switching loss) and soft recovery (low peak voltage, low EMI and high system efficiency).

In accordance with an aspect of the present disclosure, a diode structure is provided. The diode structure includes a first metallic layer, a first-type conductive semiconductor layer, a second-type conductive semiconductor layer, at least one trench portion and a second metallic layer. The first-type conductive semiconductor layer is formed on the first metallic layer. The second-type conductive semiconductor layer is formed on the first-type conductive semiconductor layer. The first-type conductive semiconductor layer and the second-type conductive semiconductor layer have opposite conductivity. A PN junction is formed between the first-type conductive semiconductor layer and the second-type conductive semiconductor layer. The at least one trench portion is located through the second-type conductive semiconductor layer and the first-type conductive semiconductor layer. A first contact surface is formed between the at least one trench portion and the first-type conductive semiconductor layer, and a second contact surface is formed between the at least one trench portion and the second-type conductive semiconductor layer. The second metallic layer is formed on the second-type conductive semiconductor layer and the at least one trench portion.

In an embodiment, the trench portion is formed by a polysilicon material layer, and an oxide layer is disposed between the polysilicon material layer and the first-type conductive semiconductor layer and disposed between the polysilicon material layer and the second-type conductive semiconductor layer.

In an embodiment, the trench portion is formed by a conductive material layer, and an oxide layer is disposed between the polysilicon material layer and the first-type conductive semiconductor layer and disposed between the polysilicon material layer and the second-type conductive semiconductor layer.

In an embodiment, the first-type conductive semiconductor layer is an N-type conductive semiconductor layer, and the second-type conductive semiconductor layer is a P+-type conductive semiconductor layer.

In an embodiment, the area of the first contact surface is smaller than the area of the second contact surface.

In an embodiment, the second-type conductive semiconductor layer extends from a sidewall of the at least one trench portion toward a bottom of the at least one trench portion.

In an embodiment, the first metallic layer is a cathode electrode, and the second metallic layer is an anode electrode.

In an embodiment, the diode structure further includes a first-type doped conductive semiconductor layer disposed between the first metallic layer and the first-type conductive semiconductor layer.

In an embodiment, the at least one trench portion encloses at least one region to define a semiconductor unit.

In accordance with another aspect of the present disclosure, a manufacturing method of a diode structure is provided. The manufacturing method includes steps of: (a) providing a substrate, wherein the substrate comprises a first metallic layer and a first-type conductive semiconductor layer, and the first-type conductive semiconductor layer is formed on the first metallic layer; (b) forming at least one trench located through the first-type conductive semiconductor layer from a surface of the first-type conductive semiconductor layer; (c) doping a second-type conductive semiconductor material into a part of the first-type conductive semiconductor layer through the surface of the first-type conductive semiconductor layer to form a second-type conductive semiconductor layer, wherein the first-type conductive semiconductor layer and the second-type conductive semiconductor layer have opposite conductivity, and a PN junction is formed between the first-type conductive semiconductor layer and the second-type conductive semiconductor layer; (d) filling a conductive material into the at least one trench to form at least one trench portion, wherein a first contact surface is formed between the at least one trench portion and the first-type conductive semiconductor layer, and a second contact surface is formed between the at least one trench portion and the second-type conductive semiconductor layer; and (e) forming a second metallic layer on the second-type conductive semiconductor layer and the at least one trench portion.

In an embodiment, the step (b) comprises steps of: (b1) etching the first-type conductive semiconductor layer to form the at least one trench; and (b2) forming an oxide layer on an inner wall of the at least one trench.

In an embodiment, the conductive material is a poly silicon material or a metallic material.

In an embodiment, the first-type conductive semiconductor layer is an N-type conductive semiconductor layer, and the second-type conductive semiconductor layer is a P+-type conductive semiconductor layer.

In an embodiment, the area of the first contact surface is smaller than the area of the second contact surface.

In an embodiment, the second-type conductive semiconductor layer extends from a sidewall of the at least one trench portion toward a bottom of the at least one trench portion.

In an embodiment, the second-type conductive semiconductor layer is formed by a diffusion method or an ion implantation method.

In an embodiment, the first metallic layer is a cathode electrode, and the second metallic layer is an anode electrode.

In an embodiment, the substrate further comprises a first-type doped conductive semiconductor layer disposed between the first metallic layer and the first-type conductive semiconductor layer.

In an embodiment, the at least one trench portion encloses at least one region to define a semiconductor unit.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a cross sectional view illustrating a diode structure according to a first embodiment of the present disclosure;
FIGS. 2A to 2F are cross sectional views illustrating the diode structure at several manufacturing stages according to the first embodiment of the present disclosure;
FIG. 3 is a flow chart showing a manufacturing method of a diode structure according to a first embodiment of the present disclosure;
FIG. 4 is a cross sectional view illustrating a diode structure according to a second embodiment of the present disclosure; and
FIG. 5 is an exemplary structure of the trench according to the embodiment of the present disclosure.

### DETAILED DESCRIPTION OF THE PREFERRED EMBODIMENT

The present disclosure will now be described more specifically with reference to the following embodiments. It should be noted that the following descriptions of preferred embodiments of this disclosure are presented herein for purpose of illustration and description only. It is not intended to be exhaustive or to be limited to the precise form disclosed.

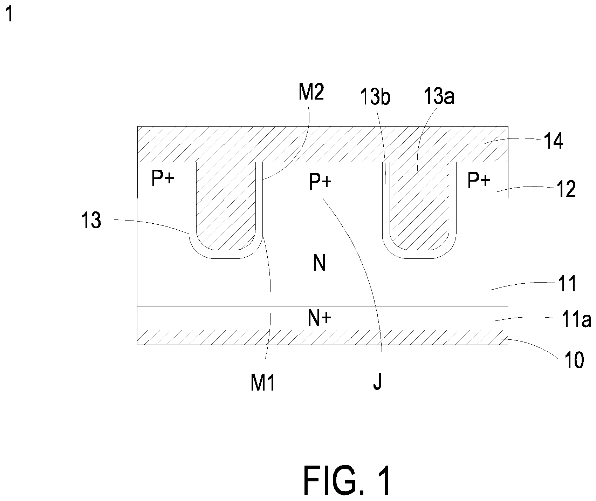

FIG. 1 is a cross sectional view illustrating a diode structure according to a first embodiment of the present disclosure. In the embodiment, the diode structure 1 is for example but not limited to a first-recovery epitaxial diode (FRED). The diode structure 1 includes a first metallic layer 10, a first-type conductive semiconductor layer 11, a second-type conductive semiconductor layer 12, at least one trench portion 13 and a second metallic layer 14. Preferably but not exclusively, the first-type conductive semiconductor layer 11 is an N-type conductive semiconductor layer and formed on the first metallic layer 10. Preferably but not exclusively, the second-type conductive semiconductor layer 12 is a P+-type conductive semiconductor layer and formed on the first-type conductive semiconductor layer 11. The first-type conductive semiconductor layer 11 and the second-type conductive semiconductor layer 12 have opposite conductivity. A PN junction J is formed between the first-type conductive semiconductor layer 11 and the second-type conductive semiconductor layer 12. In the embodiment, the diode structure 1 further includes a first-type doped conductive semiconductor layer 11a disposed between the first metallic layer 10 and the first-type conductive semiconductor layer 11. Preferably but not exclusively, the first-type doped conductive semiconductor layer 11a is an N+-type conductive semiconductor layer. The at least one trench portion 13 is located through the second-type conductive semiconductor layer 12 and the first-type conductive semiconductor layer 11. A first contact surface M1 is formed between the at least one trench portion 13 and the first-type conductive semiconductor layer 11, and a second contact surface M2 is formed between the at least one trench portion 13 and the second-type conductive semiconductor layer 12. The second metallic layer 14 is formed on the second-type conductive semiconductor layer 12 and the at least one trench portion 13. In the embodiment, the trench portion 13 is formed by a polysilicon material layer 13a, and an oxide layer 13b is disposed between the polysilicon material layer 13a and the first-type conductive semiconductor layer 11 and disposed between the polysilicon material layer 13a and the second-type conductive semiconductor layer 12. Preferably but not exclusively, the first metallic layer 10 is a cathode electrode, and the second metallic layer 14 is an anode electrode. Thus, the diode structure 1 is configured to form a trench merged PIN Schottky diode. By utilizing the structure of trench portion 13, the high voltage range of the breakdown voltage of the reverse bias of the diode structure 1 is improved. For example, the diode structure 1 has the breakdown voltage ranged from 1200V to 1800V. At the same time, the snapback issue is eliminated and the high-frequency requirements are met. It benefits to achieve the purposes of optimizing the characteristics of fast recovery time (low switching loss) and soft recovery (low peak voltage, low EMI and high system efficiency).

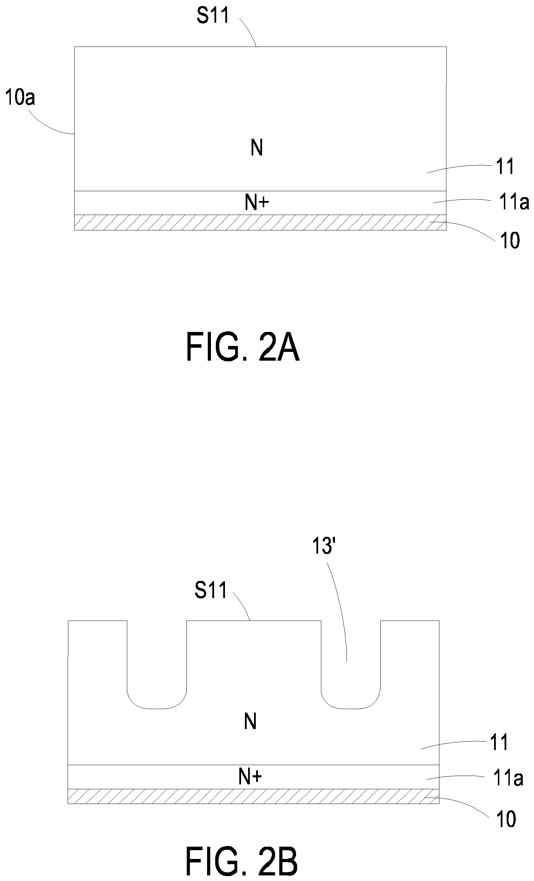

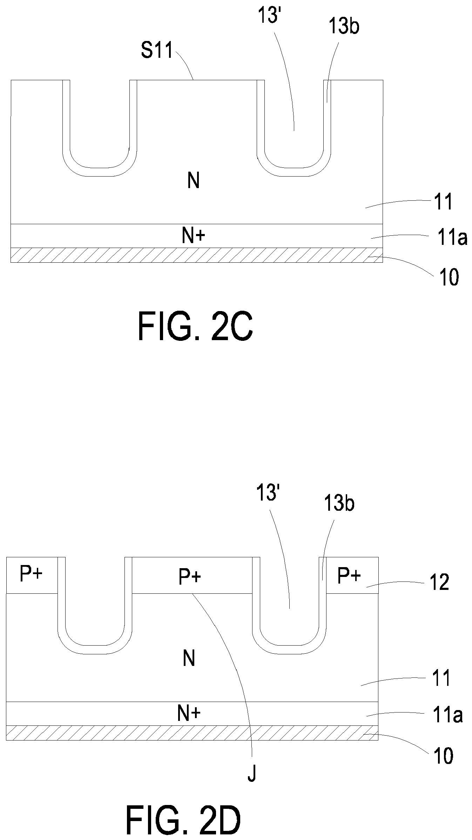

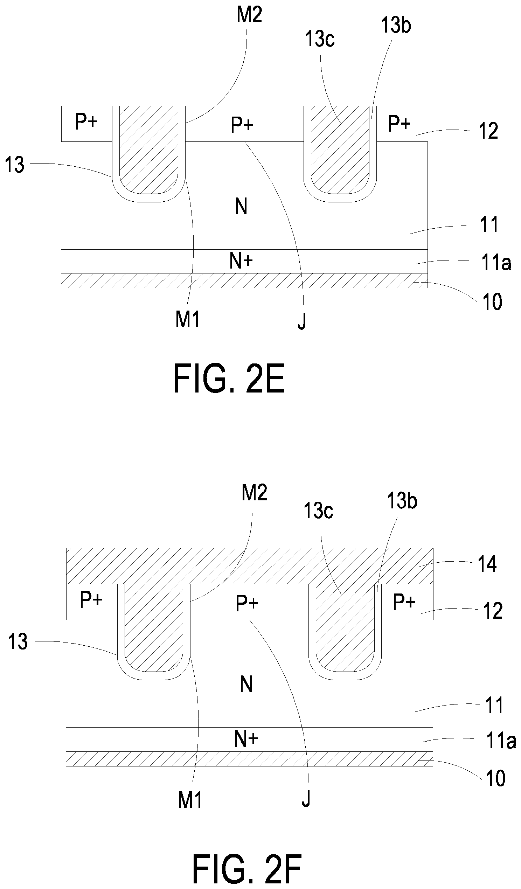

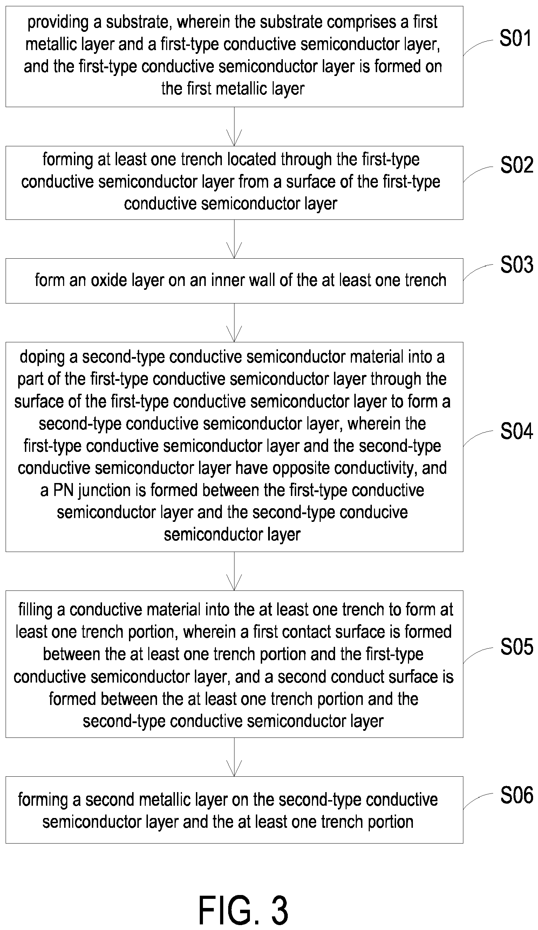

According to the foregoing diode structure 1, the present disclosure further provides a manufacturing method of a diode structure. FIGS. 2A to 2F are cross sectional views illustrating the diode structure at several manufacturing stages according to the first embodiment of the present disclosure. FIG. 3 is a flow chart showing a manufacturing method of a diode structure according to a first embodiment of the present disclosure. Firstly, at the step S01, a substrate 10a is provided. In the embodiment, the substrate 10a includes a first metallic layer 10 and a first-type conductive semiconductor layer 11, and the first-type conductive semiconductor layer 11 is formed on the first metallic layer 10, as shown in FIG. 2A. Preferably but not exclusively, the first-type conductive semiconductor layer 11 is an N-type conductive semiconductor layer. In the embodiment, the diode structure 1 further includes a first-type doped conductive semiconductor layer 11a disposed between the first metallic layer 10 and the first-type conductive semiconductor layer 11. Preferably but not exclusively, the first-type doped conductive semiconductor layer 11a is an N+-type conductive semiconductor layer. Certainly, the present disclosure is not limited thereto. Then, at the step S02, the first-type conductive semiconductor layer 11 is etched to form at least one trench 13'. The at least one trench 13' is located through the first-type conductive semiconductor layer 11 from a surface S11 of the first-type conductive semiconductor layer 11, as shown in FIG. 2B. Thereafter, at the step S03, an oxide layer 13b is formed on an inner wall of the at least one trench 13', as shown in FIG. 2C. At the step S04, a second-type conductive semiconductor material is doped into a part of the first-type conductive semiconductor layer 11 through the surface S11 (referred to FIG. 2C) of the first-type conductive semiconductor layer 11 to form a second-type conductive semiconductor layer 12, as shown in FIG. 2D. In the embodiment, the second-type conductive semiconductor layer 12 is formed by a diffusion method or an ion implantation method. Preferably but not exclusively, the second-type conductive semiconductor layer 12 is a P+-type conductive semiconductor layer and formed on the first-type conductive semiconductor layer 11. The first-type conductive semiconductor layer 11 and the second-type conductive semiconductor layer 12 have opposite conductivity. A PN junction J is formed between the first-type conductive semiconductor layer 11 and the second-type conductive semiconductor layer 12. Certainly, the conductivity of the first-type conductive semiconductor layer 11 and the second-type conductive semiconductor layer 12 can be varied according to the practical requirements, and the present disclosure is not limited thereto. Afterward, at the step S05, a conductive material layer 13c is filled into the at least one trench 13' to form at least one trench portion 13 located through the first-type conductive semiconductor layer 11 and the second-type conductive semiconductor layer 12. Consequently, a first contact surface M1 is formed between the at least one trench portion 13 and the first-type conductive semiconductor layer 11, and a second contact surface M2 is formed between the at least one trench portion 13 and the second-type conductive semiconductor layer 12. Finally, at the step S06, a second metallic layer 14 is formed on the second-type conductive semiconductor layer 12 and the at least one trench portion 13. Thus, the diode structure 1 of the present disclosure is obtained. In the embodiment, the conductive material layer 13c is formed by a polysilicon material or a metallic material, but not limited thereto. In an embodiment, the conductive material layer 13c can be replaced by a polysilicon material layer 13a, as shown in FIG. 1. In other embodiments, the materials of the first metallic layer 10, the second metallic layer 14 and the conductive material layer 13c are adjustable according to practical requirements. The present disclosure is not limited thereto, and not be redundantly described herein.

It is noted that the trench portion 13 is introduced into the diode structure 1, and it benefits to control the doping of the conductive semiconductor material in the manufacturing process. Consequently, the accuracy of the interface of the PN junction J between the first-type conductive semiconductor layer 11 and the second-type conductive semiconductor layer 12 is improved, and the performance of the diode structure 1 optimized. Moreover, the diode structure 1 forms a trench merged PIN Schottky diode, which improves the high voltage range of the breakdown voltage of the reverse bias. For example, the diode structure 1 has the breakdown voltage ranged from 1200V to 1800V. At the same time, the snapback issue is eliminated and the high-frequency requirements are met. It benefits to achieve the purposes of optimizing the characteristics of fast recovery time (low switching loss) and soft recovery (low peak voltage, low EMI and high system efficiency).

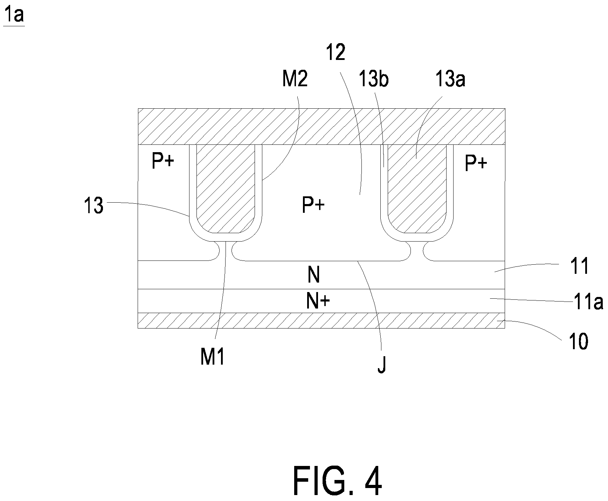

FIG. 4 is a cross sectional view illustrating a diode structure according to a second embodiment of the present disclosure. In the embodiment, the structures, elements and functions of the diode structure 1a are similar to those of the diode structure 1 in FIG. 1, and are not redundantly described herein. Different from the diode structure 1 of FIG.1, in the embodiment, the second-type conductive semiconductor layer 12 further extends from a sidewall of the at least one trench portion 13 toward a bottom of the at least one trench portion 13. Consequently, the area of the first contact surface M1 formed between the at least one trench portion 13 and the first-type conductive semiconductor layer 11 is smaller than the area of the second contact surface M2 formed between the at least one trench portion 13 and the second-type conductive semiconductor layer 12. It is possible to control, for example, the Schottky channel mode to further optimize the characteristics of the diode structure 1a. It benefits to achieve the purposes of optimizing the characteristics of fast recovery time (low switching loss) and soft recovery (low peak voltage, low EMI and high system efficiency).

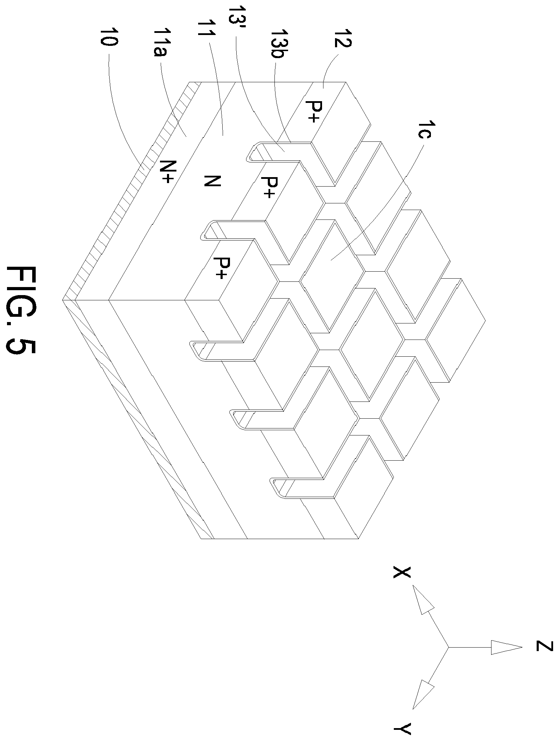

FIG. 5 is an exemplary structure of the trench according to the embodiment of the present disclosure. In the embodiment, the trenches 13' are arranged in two dimensions. For example, a part of trenches 13' are arranged along a direction parallel to the X-axis and a part of trenches 13' are arranged along a direction parallel to the Y-axis. The trenches 13' enclose at least one region to define at least one semiconductor unit 1c. Namely, with the design of the trench 13', the at least one trench portion 13 further encloses at least one region to define the semiconductor unit 1c. In addition to the ease of controlling the doping in the manufacturing process as described above, it is more advantageous of increasing the unit density of the diode structure and minimizing the entire structure. It has to be emphasized that the design of the trenches 13' is adjustable according to the practical requirements. In the embodiment, the profile on the top of the at least one semiconductor unit 1c is square. In other embodiments, with the enclosing by the trenches 13', the profile on the top of the at least one semiconductor unit 1c can be for example but not limited to circular, hexagonal or rhombic. The present disclosure is not limited thereto, and not be redundantly described herein. Moreover, it is noted that, in the embodiment, the semiconductor unit 1c defined by the trenches 13' can be for example a PIN diode unit or a Schottky diode unit. In other embodiments, by utilizing the design of the trenches 13', it benefits to set the proportion and arrangement of the PIN diode units or the Schottky diode units according to the electrical performance. The present disclosure is not limited thereto, and not be redundantly described herein.

In summary, the present disclosure provides a diode structure and a method thereof. A trench portion is constructed into the diode structure to form a trench merged PIN Schottky diode structure. It benefits to minimize the size of entire structure and optimize the characteristics of the diode structure at the same time. Moreover, by introducing a trench portion into the diode structure, it benefits to control the doping of the conductive semiconductor material in the manufacturing process, so as to improve the accuracy of the interface between the different conductive semiconductor layers and optimize the performance of the diode structure. On the other hand, the design of the trench portion can be varied according to the practical requirements to define a semiconductor unit, so that the unit density of the diode structure is increased, the snapback issue is eliminated, and the high-frequency requirements are met. It benefits to achieve the purposes of optimizing the characteristics of fast recovery time (low switching loss) and soft recovery (low peak voltage, low EMI and high system efficiency).

## Claims

1. A diode structure (1), comprising:
a first metallic layer (10);
a first-type conductive semiconductor layer (11) formed on the first metallic layer (10);
a second-type conductive semiconductor layer (12) formed on the first-type conductive semiconductor layer (11), wherein the first-type conductive semiconductor layer (11) and the second-type conductive semiconductor layer (12) have opposite conductivity, and a PN junction (J) is formed between the first-type conductive semiconductor layer (11) and the second-type conductive semiconductor layer (12);
at least one trench portion (13) located through the second-type conductive semiconductor layer (12) and the first-type conductive semiconductor layer (11), wherein a first contact surface (M1) is formed between the at least one trench portion (13) and the first-type conductive semiconductor layer (11), and a second contact surface (M2) is formed between the at least one trench portion (13) and the second-type conductive semiconductor layer (12); and
a second metallic layer (14) formed on the second-type conductive semiconductor layer (12) and the at least one trench portion (13).

2. The diode structure (1) according to claim 1, wherein the trench portion (13) is formed by a polysilicon material layer (13a), and an oxide layer (13b) is disposed between the polysilicon material layer (13a) and the first-type conductive semiconductor layer (11) and disposed between the polysilicon material layer (13a) and the second-type conductive semiconductor layer (12).

3. The diode structure (1) according to claim 1, wherein the trench portion (13) is formed by a conductive material layer (13c), and an oxide layer (13b) is disposed between the polysilicon material layer (13c) and the first-type conductive semiconductor layer (11) and disposed between the polysilicon material layer (13c) and the second-type conductive semiconductor layer (12).

4. The diode structure (1) according to claim 1, wherein the first-type conductive semiconductor layer (11) is an N-type conductive semiconductor layer, and the second-type conductive semiconductor layer (12) is a P+-type conductive semiconductor layer, wherein the first metallic layer (10) is a cathode electrode, and the second metallic layer (14) is an anode electrode.

5. The diode structure (1) according to claim 1, wherein the area of the first contact surface (M1) is smaller than the area of the second contact surface (M2), wherein the second-type conductive semiconductor layer (12) extends from a sidewall of the at least one trench portion (13) toward a bottom of the at least one trench portion (13).

6. The diode structure (1) according to claim 1, further comprising a first-type doped conductive semiconductor layer (11a) disposed between the first metallic layer (10) and the first-type conductive semiconductor layer (11).

7. The diode structure (1) according to claim 1, wherein the at least one trench portion (13) encloses at least one region to define a semiconductor unit (1c).

8. A manufacturing method of a diode structure (1), comprising steps of:
(a) providing a substrate (10a), wherein the substrate (10a) comprises a first metallic layer (10) and a first-type conductive semiconductor layer (10), and the first-type conductive semiconductor layer (11) is formed on the first metallic layer (10);
(b) forming at least one trench (13') located through the first-type conductive semiconductor layer (11) from a surface (S11) of the first-type conductive semiconductor layer (11);
(c) doping a second-type conductive semiconductor material into a part of the first-type conductive semiconductor layer (11) through the surface (S11) of the first-type conductive semiconductor layer (11) to form a second-type conductive semiconductor layer (12), wherein the first-type conductive semiconductor layer (11) and the second-type conductive semiconductor layer (12) have opposite conductivity, and a PN junction (J) is formed between the first-type conductive semiconductor layer (11) and the second-type conductive semiconductor layer (12);
(d) filling a conductive material into the at least one trench (13') to form at least one trench portion (13), wherein a first contact surface (M1) is formed between the at least one trench portion (13) and the first-type conductive semiconductor layer (11), and a second contact surface (M2) is formed between the at least one trench portion (13) and the second-type conductive semiconductor layer (12); and
(e) forming a second metallic layer (14) on the second-type conductive semiconductor layer (12) and the at least one trench portion (13).

9. The manufacturing method of the diode structure (1) according to claim 8, wherein the step (b) comprises steps of:
(b1) etching the first-type conductive semiconductor layer (11) to form the at least one trench (13'); and
(b2) forming an oxide layer (13b) on an inner wall of the at least one trench (13').

10. The manufacturing method of the diode structure (1) according to claim 8, wherein the conductive material is a polysilicon material or a metallic material.

11. The manufacturing method of the diode structure (1) according to claim 8, wherein the first-type conductive semiconductor layer (11) is an N-type conductive semiconductor layer, and the second-type conductive semiconductor layer (12) is a P+-type conductive semiconductor layer, wherein the first metallic layer (10) is a cathode electrode, and the second metallic layer (14) is an anode electrode.

12. The manufacturing method of the diode structure (1) according to claim 8, wherein the area of the first contact surface (M1) is smaller than the area of the second contact surface (M2), wherein the second-type conductive semiconductor layer (12) extends from a sidewall of the at least one trench portion (13) toward a bottom of the at least one trench portion (13).

13. The manufacturing method of the diode structure (1) according to claim 8, wherein the second-type conductive semiconductor layer (12) is formed by a diffusion method or an ion implantation method.

14. The manufacturing method of the diode structure (1) according to claim 8, wherein the substrate (10a) further comprises a first-type doped conductive semiconductor layer (11a) disposed between the first metallic layer (10) and the first-type conductive semiconductor layer (11).

15. The manufacturing method of the diode structure (1) according to claim 8, wherein the at least one trench portion (13) encloses at least one region to define a semiconductor unit (1c).

## Amended claims

### Amended claims in accordance with Rule 137(2) EPC.

1. A diode structure (1), comprising:
a first metallic layer (10);
a first-type conductive semiconductor layer (11) formed on the first metallic layer (10);
a second-type conductive semiconductor layer (12) formed on the first-type conductive semiconductor layer (11), wherein the first-type conductive semiconductor layer (11) and the second-type conductive semiconductor layer (12) have opposite conductivity, and a PN junction (J) is formed between the first-type conductive semiconductor layer (11) and the second-type conductive semiconductor layer (12);
at least one trench portion (13) located through the second-type conductive semiconductor layer (12) and the first-type conductive semiconductor layer (11), and formed by a conductive material and an oxide layer (13b), wherein the oxide layer (13b) is disposed between the conductive material and the first-type conductive semiconductor layer and disposed between the conductive material and the second-type conductive semiconductor layer (12), wherein a first contact surface (M1) is formed between the at least one trench portion (13) and the first-type conductive semiconductor layer (11), and a second contact surface (M2) is formed between the at least one trench portion (13) and the second-type conductive semiconductor layer (12), wherein the area of the first contact surface (M1) is smaller than the area of the second contact surface (M2), wherein the second-type conductive semiconductor layer (12) extends from a sidewall of the at least one trench portion (13) toward a bottom of the at least one trench portion (13); and
a second metallic layer (14) formed on the second-type conductive semiconductor layer (12) and the at least one trench portion (13).

2. The diode structure (1) according to claim 1, wherein the conductive material is a polysilicon material layer (13a), and the oxide layer (13b) is disposed between the polysilicon material layer (13a) and the first-type conductive semiconductor layer (11) and disposed between the polysilicon material layer (13a) and the second-type conductive semiconductor layer (12).

3. The diode structure (1) according to claim 1, wherein the conductive material is a conductive material layer (13c), and the oxide layer (13b) is disposed between the conductive_material layer (13c) and the first-type conductive semiconductor layer (11) and disposed between the conductive material layer (13c) and the second-type conductive semiconductor layer (12).

4. The diode structure (1) according to claim 1, wherein the first-type conductive semiconductor layer (11) is an N-type conductive semiconductor layer, and the second-type conductive semiconductor layer (12) is a P+ - type conductive semiconductor layer, wherein the first metallic layer (10) is a cathode electrode, and the second metallic layer (14) is an anode electrode.

5. The diode structure (1) according to claim 1, further comprising a first-type doped conductive semiconductor layer (11a) disposed between the first metallic layer (10) and the first-type conductive semiconductor layer (11).

6. The diode structure (1) according to claim 1, wherein the at least one trench portion (13) encloses at least one region to define a semiconductor unit (1c).

7. A manufacturing method of a diode structure (1), comprising steps of:
(a) providing a substrate (10a), wherein the substrate (10a) comprises a first metallic layer (10) and a first-type conductive semiconductor layer (10), and the first-type conductive semiconductor layer (11) is formed on the first metallic layer (10);
(b) forming at least one trench (13') and an oxide layer (13b) located through the first-type conductive semiconductor layer (11) from a surface (S11) of the first-type conductive semiconductor layer (11), wherein the oxide layer (13b) is formed on an inner wall of the at least one trench (13');
(c) doping a second-type conductive semiconductor material into a part of the first-type conductive semiconductor layer (11) through the surface (S11) of the first-type conductive semiconductor layer (11) to form a second-type conductive semiconductor layer (12), wherein the first-type conductive semiconductor layer (11) and the second-type conductive semiconductor layer (12) have opposite conductivity, and a PN junction (J) is formed between the first-type conductive semiconductor layer (11) and the second-type conductive semiconductor layer (12);
(d) filling a conductive material into the at least one trench (13') to form at least one trench portion (13), wherein a first contact surface (M1) is formed between the at least one trench portion (13) and the first-type conductive semiconductor layer (11), and a second contact surface (M2) is formed between the at least one trench portion (13) and the second-type conductive semiconductor layer (12), wherein the area of the first contact surface (M1) is smaller than the area of the second contact surface (M2), wherein the second-type conductive semiconductor layer (12) extends from a sidewall of the at least one trench portion (13) toward a bottom of the at least one trench portion (13); and
(e) forming a second metallic layer (14) on the second-type conductive semiconductor layer (12) and the at least one trench portion (13).

8. The manufacturing method of the diode structure (1) according to claim 8, wherein the step (b) comprises steps of:
(b1) etching the first-type conductive semiconductor layer (11) to form the at least one trench (13'); and
(b2) forming the oxide layer (13b) on the inner wall of the at least one trench (13').

9. The manufacturing method of the diode structure (1) according to claim 7, wherein the conductive material is a polysilicon material or a metallic material.

10. The manufacturing method of the diode structure (1) according to claim 7, wherein the first-type conductive semiconductor layer (11) is an N-type conductive semiconductor layer, and the second-type conductive semiconductor layer (12) is a P+ - type conductive semiconductor layer, wherein the first metallic layer (10) is a cathode electrode, and the second metallic layer (14) is an anode electrode.

11. The manufacturing method of the diode structure (1) according to claim 7, wherein the second-type conductive semiconductor layer (12) is formed by a diffusion method or an ion implantation method.

12. The manufacturing method of the diode structure (1) according to claim 7, wherein the substrate (10a) further comprises a first-type doped conductive semiconductor layer (11a) disposed between the first metallic layer (10) and the first-type conductive semiconductor layer (11).

13. The manufacturing method of the diode structure (1) according to claim 7, wherein the at least one trench portion (13) encloses at least one region to define a semiconductor unit (1c).
